# DEMANDE DE BREVET EUROPEEN

(11) **EP 4 538 223 A1**
(43) Date de publication de la demande: **16.04.2025**
(21) Numéro de dépôt: 24199308.8
(22) Date de dépôt: 09.09.2024
(51) Int. Cl.: B81C 99/00

(54) **PROCÉDÉ DE FABRICATION D'UNE PIÈCE MICROMÉCANIQUE MULTINIVEAUX ET PIÈCE OBTENUE PAR LE PROCÉDÉ**

(30) Priorité: 13.10.2023 CH 11382023
(71) Demandeur: Mimotec S.A., 1950 Sion (CH)
(72) Inventeur: Genolet, Grégoire, 1926 Fully (CH); Maye, Sunny, 1950 Sion (CH); David, Jérémie, 25240 Chapelle des Bois (FR); Chevalier, Louis, 39220 Les Rousses (FR)
(74) Mandataire: P&TS SA (AG, Ltd.)

(57) **Abrégé**

La présente divulgation concerne un procédé de fabrication d'une pièce micromécanique (100) comportant la fabrication d'un moule multiniveaux (200) comprenant:
étaler au moins une couche de photorésist (61, 62) sur un substrat (50); et
structurer ladite au moins une première couche de photorésist (61, 62) de manière à former au moins une première cavité (63) définissant un premier niveau (N₁), et à former au moins une seconde cavité (64) définissant un second niveau (N₂).

Le procédé comporte en outre la formation de la pièce micromécanique (100) comprenant, dans cet ordre:
électroformer un premier niveau métallique (71) dans ladite au moins une première cavité (63);
rendre électriquement conducteur le fond de ladite au moins une seconde cavité (64); et
électroformer un second niveau métallique (72) dans ladite au moins une seconde cavité (64).
la pièce micromécanique (100) ainsi formée est ensuite libérée du moule multiniveaux (200) et du substrat (50).

## Description

### Domaine technique

La présente invention concerne un procédé de fabrication d'une pièce micromécanique multiniveaux et pièce micromécanique obtenue par le procédé. L'invention se prête à un grand nombre d'applications parmi lesquelles on remarque l'horlogerie, la production de MEMS, les composants électriques et/ou optiques de précision, la micro fluidique et beaucoup d'autres.

### Etat de la technique

La technique de micro-fabrication LIGA (Lithographie, Galvanoplastie et Moulage en Allemand) est un processus de fabrication utilisé pour créer des structures microscopiques avec une grande précision et une grande reproductibilité.

Typiquement, le procédé LIGA part d'un substrat plan, par exemple de verre, de métal, de silicium ou en polymère. Sur ce substrat est étalée une couche de résine photosensible, appelée "photorésist" qui est sensible au rayonnement lumineux. On utilise communément des photorésists dits "négatifs" qui polymérisent et deviennent insolubles après avoir été irradiés par de la lumière UV ou bien des rayons X ou des faisceaux d'électrons, mais on connaît aussi des photorésists "positifs" qui deviennent solubles après l'exposition.

Le procédé LIGA permet de produire des moules multi-niveaux comportant des cavités micrométriques traversantes remplies par un métal, par exemple cuivre, or, nickel, ou un alliage, grâce à un procédé d'électrodéposition dit électroformage. Ensuite, le métal est démoulé de la résine polymérisée restante et du substrat. On obtient un produit métallique qui reproduit fidèlement, en négatif, les cavités du moule.

La fabrication de microcomposants à plusieurs niveaux à l'aide du procédé LIGA est tributaire des problèmes d'uniformité lors du dépôt du métal dans les cavités. Par exemple, le métal électrodéposé peut prendre la forme de champignonnage ou de microcavités. Ces problèmes d'uniformité sont inhérents à la croissance galvanique et sont causés en partie par la localisation de la couche conductrice nécessaire au dépôt galvanique, en particulier sur les flancs verticaux de la structure en photorésist.

Afin de contourner ces obstacles, différentes solutions s'attachent à ne pas rendre conducteur les flancs verticaux de la structure en photorésist, ou encore, d'éliminer la couche de matériau conducteur (de l'or ou du cuivre en général) sur les flancs verticaux de la structure en photorésist, afin que le métal électroformé ne se dépose sélectivement que sur les surfaces horizontales du photorésist.

Selon une solution connue, on applique un masque dont les ouvertures sont ajustées aux surfaces horizontales des reliefs, pour que l'or ne se dépose que sur ces parties horizontales (technique dite du « shadow mask »). Pour être efficace, l'ouverture doit être très légèrement inférieure à la surface horizontale afin d'empêcher toute diffusion parasite qui viendrait déposer des particules d'or sur les flancs verticaux. Cette technique nécessite un alignement parfait entre la pièce et le masque ce qui peut se révéler très difficile sur des pièces de taille moyenne ainsi que sur des substrats de grande taille. Cette technique ne permet pas d'isoler totalement toutes les géométries et crée aussi des ombrages sur des zones qui devraient être rendues conductrices.

Le document EP 3508916 B1 décrit une méthode de fabrication de moules multiniveaux comportant des cavités micrométriques, dans laquelle une monocouche organique de protection est appliquée sélectivement sur les surfaces horizontales d'une couche de photorésist préalablement recouverte d'une couche conductrice. Le méthode permet l'électroformage homogène d'un métal sur plusieurs niveaux.

Le document EP 3547027 B1 décrit une méthode de fabrication de micromoules dans laquelle une couche conductrice est présente de manière sélective sur les surfaces horizontales supérieures visibles de chaque niveau de la cavité du micromoule obtenu. Les flancs verticaux de la cavité étant exempts de couche conductrice, l'électroformage du métal dans la cavité est plus homogène.

Dans les méthodes connues pour la fabrication de microcomposants multi-niveaux par procédé UV-LIGA, le remplissage par électroformage est réalisé soit en une seule étape, après la fabrication complète du moule, ou soit séquentiellement pour chaque niveau du moule. Ces méthodes sont cependant relativement complexes à mettre en oeuvre et ne permettent pas d'obtenir un dépôt galvanique suffisamment homogène.

Le remplissage du moule multiniveaux par électroformage en une seule étape peut être problématique dans le cas de structures compliquées, particulièrement lorsque le premier niveau comporte des structures avec des facteurs de forme élevés. Le remplissage des parties du moule avec des structures avec des facteurs de forme élevés se fera plus rapidement que le remplissage des autres structures en raison de la concentration des lignes de courant durant l'électroformage. Le contact de la couche conductrice présente sur la surface horizontale du premier niveau se fera ainsi plus rapidement, provoquant des inhomogénéités de croissance.

Le remplissage séquentiel de chaque niveau du moule se rapproche du remplissage de cavité de moule à un seul niveau. Les étapes d'usinage du métal électroformé (rectification, rodage plan, ...) vont modifier la surface horizontale supérieure du moule. Le dépôt de la couche conductrice sur le moule sera moins homogène que sur une surface qui n'a pas été rectifiée. L'adhésion de la couche conductrice sera également moins bonne sur des surfaces usinées en raison de la rugosité et des modifications de surface générées sur les surfaces horizontales du moule et du métal.

### Bref résumé de l'invention

L'invention propose de réaliser un moule multiniveaux avant d'effectuer le remplissage de ce dernier par électroformage d'un métal. Le remplissage du moule multiniveaux est réalisé en plusieurs étapes d'électroformage. La surface horizontale du niveau précédent du moule multiniveaux est rendue électriquement conductrice entre chaque étape d'électroformage. Cette solution permet d'éviter les inhomogénéités de croissance du métal électroformé, liées à un contact différencié de la surface horizontale.

Plus particulièrement, la présente divulgation concerne un procédé de fabrication d'une pièce micromécanique comportant la fabrication d'un moule multiniveaux comprenant au moins les étapes suivantes:
étaler au moins une couche de photorésist sur un substrat; et
structurer ladite au moins une première couche de photorésist de manière à former au moins une première cavité définissant un premier niveau, et à former au moins une seconde cavité définissant un second niveau;

le procédé comportant en outre la formation de la pièce micromécanique comprenant, dans cet ordre, au moins les étapes de suivantes:
   électroformer un premier niveau métallique dans ladite au moins une première cavité;
   rendre électriquement conducteur le fond de ladite au moins une seconde cavité; et
   électroformer un second niveau métallique dans ladite au moins une seconde cavité;
le procédé comportant en outre l'étape de libérer la pièce micromécanique ainsi formée du moule multiniveaux et du substrat.

Selon une forme d'exécution, l'étape de rendre électriquement conducteur comprend la formation d'une couche électriquement conductrice sur le fond de ladite au moins une seconde cavité. Dans ce cas, la solution présenté ici permet également d'éviter les problèmes d'adhésion de la couche conductrice liées à un usinage mécanique de la surface sur laquelle elle est formée.

Dans le procédé présenté ici, l'étape de la déposition galvanique du métal dans la cavité multiniveaux alterne avec l'étape de rendre électriquement conducteur le fond de la cavité.

La méthode proposée est simple à mettre en oeuvre et permet d'obtenir une bonne homogénéité du dépôt galvanique dans les cavités.

La présente divulgation concerne également une pièce micromécanique obtenue par le procédé.

### Brève description des figures

Des exemples de mise en oeuvre de l'invention sont indiqués dans la description illustrée par les figures annexées dans lesquelles :
Les figures 1a-1j illustrent un procédé de fabrication d'une pièce micromécanique, selon une forme d'exécution ;
les figures 2a-2c, illustrent le procédé de fabrication d'une pièce micromécanique, selon une autre forme d'exécution ;
la figure 3 montre un exemple de pièce micromécanique à deux niveaux fabriquée par le procédé; et
la figure 4 montre un exemple de pièce micromécanique à trois niveaux fabriquée par le procédé.

### Exemple(s) de mode de réalisation de l'invention

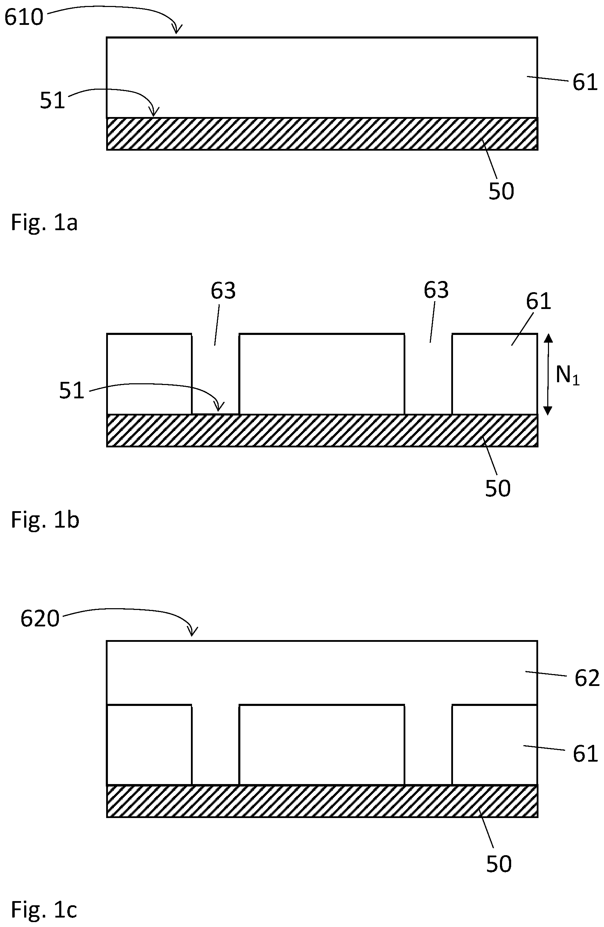

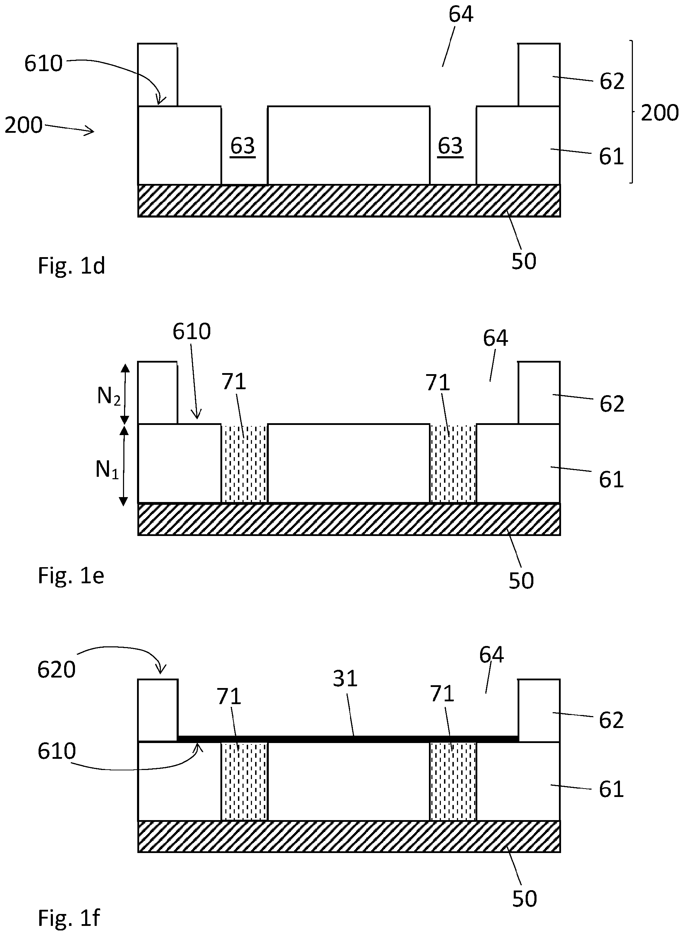

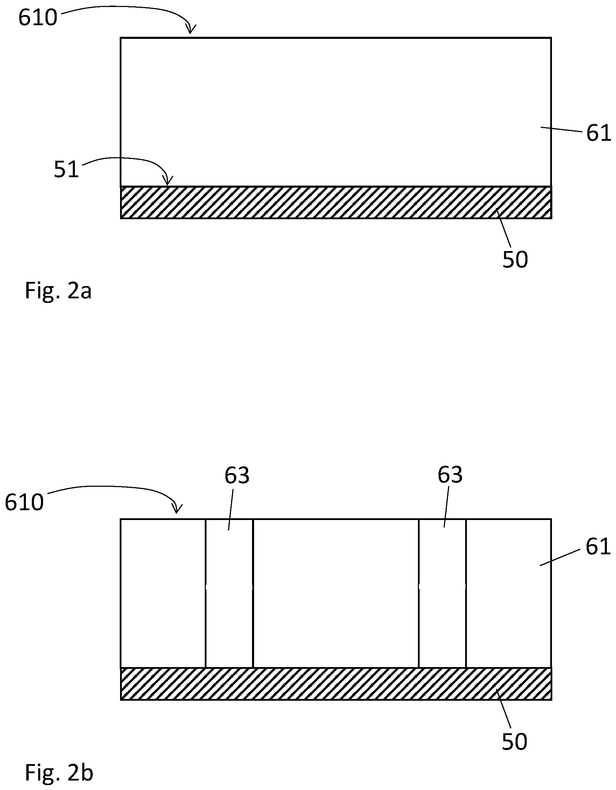

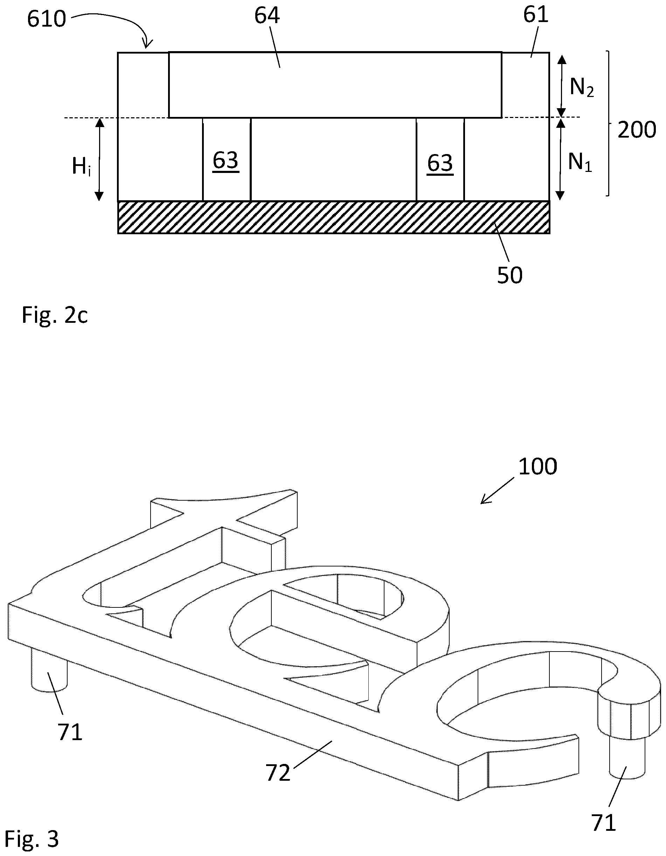

Les **figures 1a-1j** **et** **2a-2c** illustrent un procédé de fabrication d'une pièce micromécanique 100 comportant la fabrication d'un moule multiniveaux 200 (voir les figures 1d et 2c) comprenant au moins les étapes suivantes:
étaler au moins une couche de photorésist 61, 62 sur un substrat 50;
structurer ladite au moins une première couche de photorésist 61, 62 de manière à former au moins une première cavité 63 définissant un premier niveau N₁, et à former au moins une seconde cavité (64) définissant un second niveau N₂.

Le procédé comporte en outre la formation de la pièce micromécanique 100 comprenant, dans cet ordre, au moins les étapes suivantes:
électroformer un premier niveau métallique 71 dans ladite au moins une première cavité 63;
rendre électriquement conducteur le fond de ladite au moins une seconde cavité 64; et
électroformer un second niveau métallique 72 dans ladite au moins une seconde cavité 64.

Le procédé comportant en outre l'étape de libérer la pièce micromécanique 100 ainsi formée du moule multiniveaux 200 et du substrat 50.

Le procédé est ici décrit en détaillant seulement les étapes principales nécessaires à comprendre les solutions techniques utilisées par l'invention. Par exemple, un lecteur informé saura que le procédé LIGA comprend aussi d'autres étapes (préparation des surfaces, lavage, déposition de couches conductrices, dépose du photorésist, séchage, alignement, exposition, développement, ...) que l'on n'a pas indiqué dans un souci de concision.

Plus particulièrement, les **figures 1a-1j** illustrent un procédé de fabrication d'une pièce micromécanique 100 selon une forme d'exécution.

Selon un mode de réalisation, ladite au moins une première couche de photorésist comprend une première couche de photorésist 61 et une seconde couche de photorésist 62. La fabrication d'un moule multiniveaux 200 comporte au moins les étapes suivantes:
étaler une première couche de photorésist 61 sur le substrat 50;
structurer la première couche de photorésist 61 par photolithographie de manière à former au moins une première cavité 63;
étaler une seconde couche de photorésist 62 sur la première couche de photorésist 61; et
structurer la seconde couche de photorésist 62 par photolithographie de manière à former au moins une seconde cavité 64.

Selon ce mode de réalisation, le premier niveau N₁ correspond à l'épaisseur de la première couche de photorésist 61. Le second niveau N₂ correspond à l'épaisseur de la seconde couche de photorésist 62 (voir la figure 1e).

La **figure 1a** montre une coupe d'un substrat 50 sur lequel une première couche de photorésist 61 a été étalée. Le substrat 50 peut être en métal, en verre, en silicium, en polymère, ou bien tout autre matériau approprié. Plus particulièrement, le substrat 50 comprend une surface de substrat 51 électriquement conductrice. Cela peut être obtenu en utilisant un substrat 50 électriquement conducteur ou, dans le cas des substrats non-conducteurs, en interposant une couche conductrice (non représentée) entre le substrat 50 et la première couche de photorésist 61. Par exemple, le substrat 50 peut comprendre une plaque-support de verre, de métal ou de silicium sur laquelle est déposée une couche conductrice réalisée par une évaporation de chrome et d'or. Sur la surface de substrat 51 est étalée une première couche de résine photosensible (photorésist) 61.

La première couche de photorésist 61 est ensuite structurée par photolithographie afin d'y former au moins une première cavité 63 traversante laissant apparaître la surface conductrice 51 du substrat 50, et donc ayant une profondeur égale à celle de la première couche de photorésist 61. La surface de substrat 51 sert de couche d'amorçage, c'est-à-dire de cathode, lors d'un dépôt galvanique ultérieur.

Dans l'exemple de la **figure 1b****,** la première couche de photorésist 61 structurée comporte deux premières cavités 63. On comprendra cependant que la structuration par photolithographie permet de former une seule ou plus de deux premières cavités 63 dans la première couche de photorésist 61.

La **figure 1c** montre la seconde couche de photorésist 62 qui est étalée sur la première couche de photorésist 61 structurée.

La **figure 1d** montre la seconde couche de photorésist 62 structurée comportant une seconde cavité 64 ayant une profondeur égale à celle de la seconde couche de photorésist 62 déposée. Comme dans le cas de la première couche de photorésist 61 structurée, on comprendra que la structuration par photolithographie permet de former une pluralité de secondes cavités 64 dans la seconde couche de photorésist 62. La seconde cavité 64 est traversante jusqu'à la face supérieure 610 de la première couche de photorésist 61.

La structuration par photolithographie peut être réalisée à l'aide d'un photomasque (non représenté) aligné au-dessus de la face supérieure 610 de la première couche de photorésist 61 et de la face supérieure 620 de la seconde couche de photorésist 62. Le photomasque permet d'irradier sélectivement la couche de photorésist 61, 62. Le photomasque utilisé pour irradier sélectivement la première couche de photorésist 61 peut différer de celui utilisé pour d'irradier sélectivement la seconde couche de photorésist 62.

La structuration par photolithographie résulte typiquement dans des cavités 63, 64 ayant des flancs sensiblement verticaux, parallèles à la direction de l'irradiation. Notons qu'il peut également être envisagé de fabriquer des cavités 63, 64 ayant des flancs inclinés ou non verticaux. Par exemple, de tels flancs non verticaux peuvent être obtenus sur au moins une portion de la hauteur de la couche de photorésist, à l'aide d'un usinage par enlèvement de matière du flanc vertical de la cavité. Une telle approche est décrite dans la demande suisse non encore publiée CH20230000582 par la présente demanderesse.

Un solvant, appelé révélateur ou développeur, est ensuite appliqué sur la surface de la couche de photorésist 61, 62. Dans le cas d'une résine photosensible positive, la couche de photorésist 61, 62 est dégradée par la lumière et le révélateur dissout les zones exposées à la lumière. Dans le cas d'une résine photosensible négative, la couche de photorésist 61, 62 est renforcée (polymérisé ou réticulé) par la lumière et le révélateur ne dissout que les zones qui n'ont pas été exposées à la lumière. La dimension latérale (largeur) des cavités 63, 64 est définie par le photomasque.

Selon une forme d'exécution, la couche de photorésist 61, 62 peut comprendre une résine photosensible liquide de type négatif, par exemple une résine de la famille du SU-8 de Kayaku Advanced Materials. D'autres types de résines peuvent également être utilisées, par exemple une résine photosensible de type positif.

L'épaisseur de la couche de résine photosensible est typiquement comprise entre 20 et 500 microns. Selon l'épaisseur et la technique utilisée, chaque couche de photorésist 61, 62 pourra être déposée en une ou plusieurs fois.

Selon une autre forme d'exécution on peut utiliser de la résine photosensible sèche de type négative tel que mentionné dans le brevet EP 3547027 B1.

La **figure 1e** montre l'étape d'électroformer le premier niveau métallique 71 dans les premières cavités 63. Lors de l'électroformage, la surface de substrat 51 électriquement conductrice au fond de la première cavité 63 est exposée au bain galvanique, permettant la croissance du dépôt métallique dans la première cavité 63. Dans le cas où les flancs des premières cavités 63 ne sont pas électriquement conductrices, la croissance du métal sera assez uniforme et sera stoppée sensiblement jusqu'au bord supérieur de la cavité 63. Un effet de champignonnage peut cependant apparaître lorsque le métal est crû au-delà du bord supérieur de la cavité 63.

L'électroformage du premier niveau métallique 71 peut être réalisé de façon à ce que l'épaisseur du premier niveau métallique 71 soit inférieure à la profondeur de la première cavité 63. Par exemple, le premier niveau métallique 71 peut être entre 95% et 80% de la profondeur de la première cavité 63. Alternativement, l'électroformage du premier niveau métallique 71 peut être réalisé de façon à ce que l'épaisseur du premier niveau métallique 71 soit supérieure à la profondeur de la première cavité 63. Par exemple, le premier niveau métallique 71 peut être entre 105% et 120% de la profondeur de la première cavité 63.

La **figure 1f** montre l'étape de rendre électriquement conducteur le fond de la seconde cavité 64. Par exemple, la surface horizontale formée par la face supérieure de la première couche de photorésist 610 et la face supérieure des premiers niveaux métalliques 71 peut être métallisée. La métallisation peut comprendre le dépôt d'une couche électriquement conductrice 31, par exemple formée d'un empilement d'une couche de chrome et d'or. Par exemple, un dépôt de la couche électriquement conductrice 31 par vaporisation sous vide (PVD ou CVD) peut être envisagé.

Selon une forme d'exécution, le fond de ladite au moins une seconde cavité 64 peut être rendu électriquement conducteur de manière sélective.

La métallisation sélective dans le fond de la seconde cavité 64 peut, par exemple, être réalisé en masquant la face supérieure 620 de la seconde couche de photorésist 62 et en éliminant une possible métallisation formée sur les flancs verticaux de la seconde couche de photorésist 62 par attaque chimique contrôlée. Dans le cas où la métallisation est formée sur le dessus de la seconde couche de photorésist 62, elle peut être éliminée (par exemple par usinage), ou encore rendue électriquement isolante en appliquant une matière isolante (par exemple une encre). Une telle méthode de métallisation sélective est décrite dans le brevet Européen EP 3839627 B1 par la présente demanderesse.

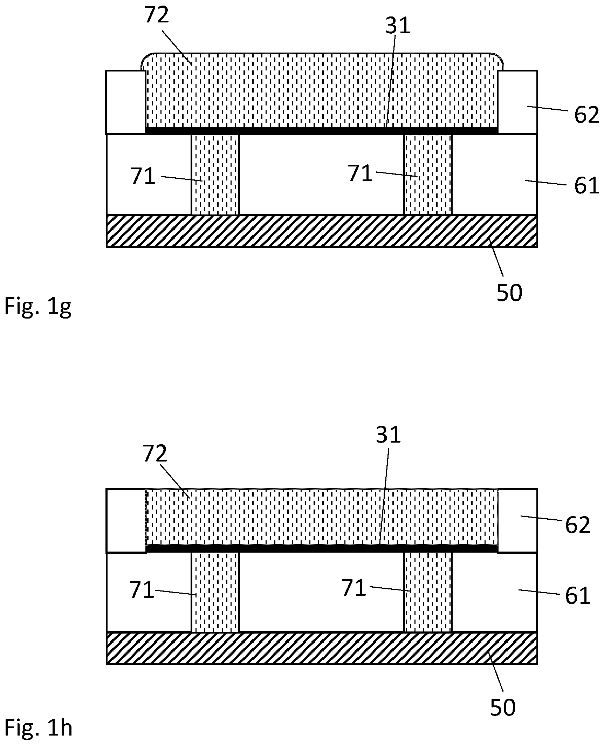

La **figure 1g** illustre l'étape d'électroformer le second niveau métallique 72 dans la seconde cavité 64. La croissance homogène du second niveau métallique 72 dans la seconde cavité 64 est possible grâce à la métallisation 31 au fond de la seconde cavité 64. L'électroformage peut être réalisé de façon à ce que l'épaisseur du second niveau métallique 72 soit inférieure à la profondeur de la seconde cavité 64. Alternativement, l'électroformage peut être réalisé de façon à ce que l'épaisseur du second niveau métallique 72 soit supérieure à la profondeur de la seconde cavité 64. Comme dans le cas du remplissage de la première cavité 63, la croissance du métal est sensiblement uniforme jusqu'au bord supérieur de la cavité 64, les effets de bords apparaissant pour des dépôts plus épais. La figure 1g montre le champignonnage au-dessus de la face supérieure de la seconde couche de photorésist 62 du second niveau métallique 72 déposé avec une épaisseur supérieure à la profondeur de la seconde cavité 64.

Les étapes d'électroformer le premier niveau métallique 71 dans les premières cavités 63, de rendre électriquement conducteur le fond de la seconde cavité 64, et d'électroformer le second niveau métallique 72 dans la seconde cavité 64 sont réalisées dans cet ordre.

Le procédé peut comprendre une étape d'usinage afin d'aplanir la surface supérieure du second niveau métallique 72 (**figure 1h**). Cette étape permet d'obtenir une surface usinée 72 unique plane sans aucun débordement. Cet usinage est réalisable par usinage mécanique, notamment par abrasion, par rectification, par meulage ou par un dressage à plat avec une fraise, ou par n'importe quel procédé de mise en oeuvre approprié. Cette usinage peut également être réalisable par usinage chimique ou mécano-chimique.

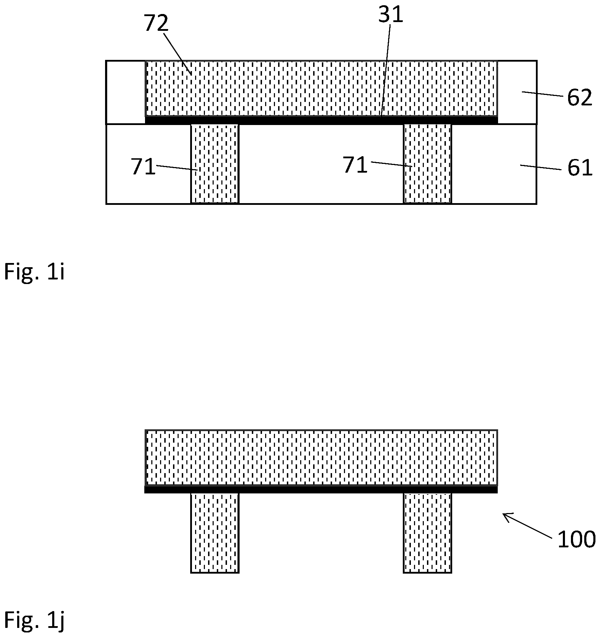

Le procédé comporte en outre une étape d'éliminer le substrat 50 (**figure 1i**). L'élimination du substrat 50 peut être obtenue par dissolution chimique, par délaminage, par usinage ou encore par sous-gravure sélective.

Le procédé comporte en outre une étape de libérer la pièce micromécanique 100 formée par les précédentes étapes dans le moule multiniveaux 200 (**figure 1j**). L'élimination du moule multiniveaux 200 peut être réalisée par décapage au plasma ou autres manières, par exemple par voie chimique ou physique. Notons que les étapes d'éliminer le substrat 50 et de libérer la pièce micromécanique 100 du moule multiniveaux 200 peuvent être effectuées dans n'importe quel ordre ou simultanément.

Selon un autre mode de réalisation illustré aux **figures 2a-2c****,** ladite au moins une première couche de photorésist comprend une seule première couche de photorésist 61. La fabrication d'un moule multiniveaux 200 peut alors comporter au moins les étapes suivantes:
étaler la première couche de photorésist 61 sur le substrat 50 (**figure 2a**);
structurer première couche de photorésist 61 par photolithographie de manière à former au moins une première cavité 63 s'étendant sur l'épaisseur totale de la première couche de photorésist 61 (**figure 2b**); et
structurer la première couche de photorésist 61 de manière à former au moins ladite au moins une seconde cavité 64 (**figure 2c**).

Le moule multiniveaux 200 ainsi fabriqué comprend la première cavité 63, définissant le premier niveau N₁ et qui s'étend entre la surface de substrat 50 et une épaisseur intermédiaire Hᵢ de la première couche de photorésist 61. Le moule multiniveaux 200 comporte également la seconde cavité 64 définissant le second niveau N₂ et qui s'étend entre l'épaisseur intermédiaire Hᵢ, correspondant au fond de la seconde cavité 64, et la face supérieure 610 de la première couche de photorésist 61.

Selon une forme d'exécution, former la première et seconde cavité 63, 64 peut être réalisée en deux temps. D'abord, au moins une première cavité 63 s'étendant sur toute l'épaisseur de la première couche de photorésist 61 est formée par photolithographie. Ensuite, ladite au moins une seconde cavité 64 est formé par usinage, depuis la face supérieure 610 de la première couche de photorésist 61 et sur une épaisseur inférieure à la première couche de photorésist 61 (épaisseur intermédiaire Hᵢ). Par exemple, ladite au moins une seconde cavité 64 peut être formée en agrandissant la dimension latérale de la première cavité 63 sur la portion de l'épaisseur de la première couche de photorésist 61. L'usinage peut par exemple comprendre une opération de lamage. La formation de la pièce micromécanique 100 reste inchangée.

Le procédé décrit ci-dessus permet d'obtenir une pièce micromécanique 100 de forme tridimensionnelle. Les dimensions latérales et en épaisseur de la pièce micromécanique 100 formée par le procédé décrit ici dépendent de l'épaisseur des couches de photorésist 61, 62 et des dimensions latérales des cavités 63, 64.

Le procédé décrit ci-dessus comprend également la fabrication d'une pièce micromécanique 100 comportant plus de deux niveaux (non illustré). Dans ce cas, la fabrication d'un moule multiniveaux 200 comprend au moins les étapes supplémentaires de structurer ladite au moins une première couche de photorésist 61, 62 de manière à former au moins une troisième cavité définissant un troisième niveau. Le troisième niveau peut être réalisé par l'usinage d'une troisième cavité dans la même couche de photorésist que pour les autres niveaux. Alternativement, Le troisième niveau peut être réalisé en étalant une troisième couche de photorésist sur la seconde couche de photorésist, et en structurant la troisième couche de photorésist par photolithographie de manière à former au moins une troisième cavité.

De plus, la formation de la pièce micromécanique 100 comportant plus de deux niveaux peut comprendre, dans cet ordre, au moins les étapes supplémentaires suivantes:
rendre électriquement conducteur le fond de ladite au moins une troisième cavité; et
électroformer un troisième niveau métallique dans ladite au moins troisième cavité.

De manière générale, le procédé de fabrication peut comporter la fabrication d'une pluralité de moules multiniveaux 200 pouvant être disposés sur tout ou partie d'une plaque-support, ainsi que la formation de la pièce micromécanique 100 dans chacun des moules multiniveaux 200, selon les modes de réalisations présentés ci-dessus.

La présente divulgation concerne également une pièce micromécanique obtenue par le procédé.

La pièce micromécanique 100 peut être utilisé dans un grand nombre d'applications parmi lesquelles on remarque l'horlogerie, la production de MEMS, les composants électriques et/ou optiques de précision, la micro fluidique et beaucoup d'autres. En particulier, la pièce micromécanique peut comprendre un composant horloger, un composant MEMS, un composant électrique et/ou optique de précision, ou un composant micro fluidique.

La figure 3 montre un exemple de pièce micromécanique 100 à deux niveaux fabriquée par le procédé décrit ci-dessus. La pièce comprend des pieds formés par premier niveau métallique 71 et des caractères alphanumériques formés par le second niveau métallique 72.

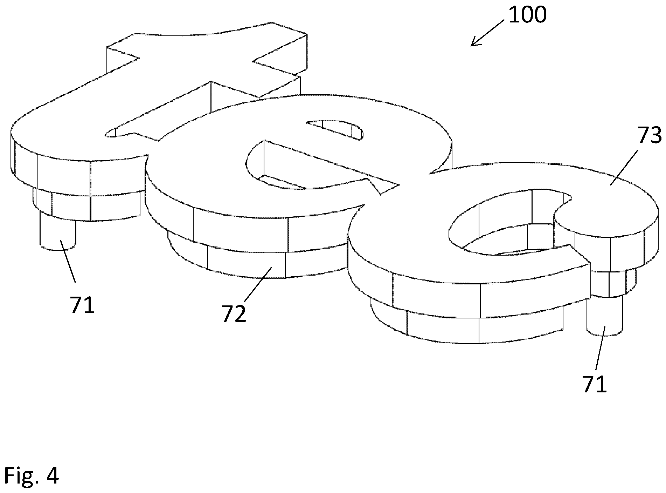

La figure 4 montre un exemple de pièce micromécanique 100 à trois niveaux fabriquée par le procédé décrit ci-dessus. La pièce comprend des pieds formés par premier niveau métallique 71 et des caractères alphanumériques formés par le second et troisième niveaux métalliques 72, 73.

### Numéros de référence employés sur les figures

- 100: pièce micromécanique
- 101: pied
- 200: moule multiniveaux
- 31: couche électriquement conductrice
- 50: substrat
- 51: surface de substrat
- 61: première couche de photorésist
- 610: face supérieure de la première couche de photorésist
- 62: seconde couche de photorésist
- 620: face supérieure de la seconde couche de photorésist
- 63: première cavité
- 64: seconde cavité
- 71: premier niveau métallique
- 72: second niveau métallique
- 73: troisième niveau métallique
- Hᵢ: hauteur intermédiaire
- N₁: premier niveau
- N₂: second niveau

## Revendications

1. Procédé de fabrication d'une pièce micromécanique (100) comportant la fabrication d'un moule multiniveaux (200) comprenant au moins les étapes suivantes:
étaler au moins une couche de photorésist (61, 62) sur un substrat (50); et
structurer ladite au moins une première couche de photorésist (61, 62) de manière à former au moins une première cavité (63) définissant un premier niveau (N₁), et à former au moins une seconde cavité (64) définissant un second niveau (N₂);
le procédé comportant en outre la formation de la pièce micromécanique (100) comprenant, dans cet ordre, au moins les étapes suivantes:
électroformer un premier niveau métallique (71) dans ladite au moins une première cavité (63);
rendre électriquement conducteur le fond de ladite au moins une seconde cavité (64); et
électroformer un second niveau métallique (72) dans ladite au moins une seconde cavité (64);
le procédé comportant en outre l'étape de libérer la pièce micromécanique (100) ainsi formée du moule multiniveaux (200) et du substrat (50).

2. Procédé de fabrication selon la revendication1,
dans lequel ladite au moins une première couche de photorésist comprend au moins une première couche de photorésist (61) et une seconde couche de photorésist (62); et
dans lequel la fabrication d'un moule multiniveaux (200) comprend au moins les étapes suivantes:
étaler une première couche de photorésist (61) sur un substrat (50);
structurer la première couche de photorésist (61) par photolithographie de manière à former au moins une première cavité (63);
étaler une seconde couche de photorésist (62) sur la première couche de photorésist (61); et
structurer la seconde couche de photorésist (62) par photolithographie de manière à former au moins une seconde cavité (64);
le procédé comportant en outre la formation de la pièce micromécanique (100) comprenant, dans cet ordre, au moins les étapes suivantes:
électroformer un premier niveau métallique (71) dans ladite au moins première cavité (63);
rendre électriquement conducteur le fond de ladite au moins une seconde cavité (64); et
électroformer un second niveau métallique (72) dans ladite au moins une seconde cavité (64);
le procédé comportant en outre l'étape de libérer la pièce micromécanique (100) ainsi formée du moule multiniveaux (200) et du substrat (50).

3. Procédé de fabrication selon la revendication1,
dans lequel ladite au moins une première couche de photorésist comprend une seule première couche de photorésist (61); et
dans lequel la fabrication d'un moule multiniveaux (200) comprend au moins les étapes suivantes:
étaler la première couche de photorésist (61) sur le substrat (50);
structurer la première couche de photorésist (61) par photolithographie de manière à former au moins une première cavité (63) s'étendant sur l'épaisseur totale de la première couche de photorésist (61); et
structurer la première couche de photorésist (61) de manière à former au moins ladite au moins une seconde cavité (64), depuis la face supérieure 610 de la première couche de photorésist (61) et sur une épaisseur inférieure à la première couche de photorésist (61).

4. Procédé selon l'une des revendications 1 à 3,
dans lequel l'épaisseur du premier niveau métallique (71) est inférieure à la profondeur de ladite au moins une première cavité (63), notamment d'environ 80% la profondeur de ladite au moins une première cavité (63)..

5. Procédé selon l'une des revendications 1 à 3,
dans lequel l'épaisseur du premier niveau métallique (71) est supérieure à la profondeur de ladite au moins une première cavité (63), notamment d'environ 120% la profondeur de ladite au moins une première cavité (63).

6. Procédé selon l'une des revendications de 1 à 5,
dans lequel l'épaisseur du second niveau métallique (72) est supérieure à la profondeur de ladite au moins une seconde cavité (64).

7. Procédé selon l'une des revendications de 1 à 6,
comprenant une étape de rectification pour aplanir la surface supérieure du second dépôt métallique (72).

8. Procédé selon l'une des revendications de 1 à 7,
comprenant une étape de retrait du substrat (50).

9. Procédé selon l'une des revendications de 1 à 8,
comprenant une étape de libérer la pièce micromécanique (100) formée par les précédentes étapes de fabrication du moule multiniveaux (200).

10. Procédé selon l'une des revendications de 1 à 9,
dans lequel le fond de ladite au moins une seconde cavité (64) est rendu électriquement conducteur de manière sélective.

11. Procédé selon l'une des revendications de 1 à 9,
dans lequel la fabrication d'un moule multiniveaux (200) comprend au moins les étapes supplémentaires de structurer ladite au moins une première couche de photorésist (61, 62) de manière à former au moins une troisième cavité définissant un troisième niveau; et
dans lequel la formation de la pièce micromécanique 100 comportant plus de deux niveaux peut comprendre, dans cet ordre, au moins les étapes supplémentaires suivantes:
rendre électriquement conducteur le fond de ladite au moins une troisième cavité; et
électroformer un troisième niveau métallique dans ladite au moins troisième cavité.

12. Procédé selon la revendication 11,
dans lequel le fond de ladite au moins une troisième cavité est rendu électriquement conducteur de manière sélective.

13. Procédé selon l'une des revendications de 1 à 12,
dans lequel structurer ladite au moins une première couche de photorésist comprend une troisième couche de photorésist; et
dans lequel la fabrication d'un moule multiniveaux (200) comprend au moins les étapes suivantes:
étaler la troisième couche de photorésist sur la seconde couche de photorésist (62); et
structurer la troisième couche de photorésist par photolithographie de manière à former au moins une troisième cavité.

14. Procédé selon l'une des revendications de 3 à 12,
dans lequel la fabrication d'un moule multiniveaux (200) comprend au moins une étape supplémentaire de structurer la première couche de photorésist (61) par photolithographie de manière à former au moins une troisième cavité.

15. Procédé selon l'une des revendications de 3 à 14,
dans lequel la seconde cavité (64) est formée par usinage.

16. Pièce micromécanique (100) obtenue par le procédé selon les revendications 1 à 15.

17. Pièce micromécanique (100) selon la revendication 16, comprenant un composant horloger, MEMS, un composant électrique et/ou optique de précision, ou un composant micro fluidique.
